Europäisches Patentamt

European Patent Office

Office européen des brevets

(11) Veröffentlichungsnummer: **0 643 483 A1**

(12) **EUROPÄISCHE PATENTANMELDUNG**

(21) Anmeldenummer: **94109379.1**

(22) Anmeldetag: **17.06.94**

(51) Int. Cl.⁶: **H03H 17/02**

(30) Priorität: **26.08.93 DE 4328497**

(43) Veröffentlichungstag der Anmeldung:
**15.03.95 Patentblatt 95/11**

(84) Benannte Vertragsstaaten:
**FR GB IT**

(71) Anmelder: **ANT Nachrichtentechnik GmbH**
**Gerberstrasse 33**

**D-71522 Backnang (DE)**

(72) Erfinder: **Göckler, Heinz, Dr.**
**Elbinger Strasse 52**
**D-71522 Backnang (DE)**
Erfinder: **Gebauer, Thomas**
**Im Reutle 36**
**D-71573 Allmersbach im Tal (DE)**

(54) **Digitale Filterbank.**

(57) Digitale Filterbank zur frequenzmäßigen Trennung eines mit der Abtastfrequenz $f_A$ abgetasteten aus höchstens L Einzelsignalen der Bandbreite B zusammengesetzten Frequenzmultiplexsignals, wobei ein reelles Eingangssignal in ein komplexes Ausgangssignal umgewandelt und die Abtastrate verkleinert wird, dadurch gekennzeichnet,

daß das reelle Eingangssignal mittels eines rotierenden Schalters im Takte der Eingangsabtastrate auf M Filterzweige verteilt wird, wobei die Verarbeitungsrate in den Filterzweigen um den Faktor M herabgesetzt wird,

daß in den einzelnen Filterzweigen für den p-ten Filterzweig die Abtastproben des Eingangssignals mit den Filterkoeffizienten multipliziert und zu den komplexen Filter-Zweig-Ausgangssignalen zusammengefasst werden und

daß die Filterzweigausgangssignale mittels komplexer Multiplikation frequenzverschoben und zusammengefasst werden zu komplexen Filtergangausgangssignalen.

Einsatz in HMM-Multiplexern bzw. Demultiplexern, insbesondere für Vielkanal- und Breitbandkanalsystemen, bei denen die Eingangsabtastrate des Demultiplexers bzw. Ausgangsabtastrate des Multiplexers zu hoch ist, als daß sie für die Signalverarbeitung mit gängiger Technologie auch nach der üblichen Abtastratenhalbierung der Eingangsstufe realisierbar ist.

Fig. 4

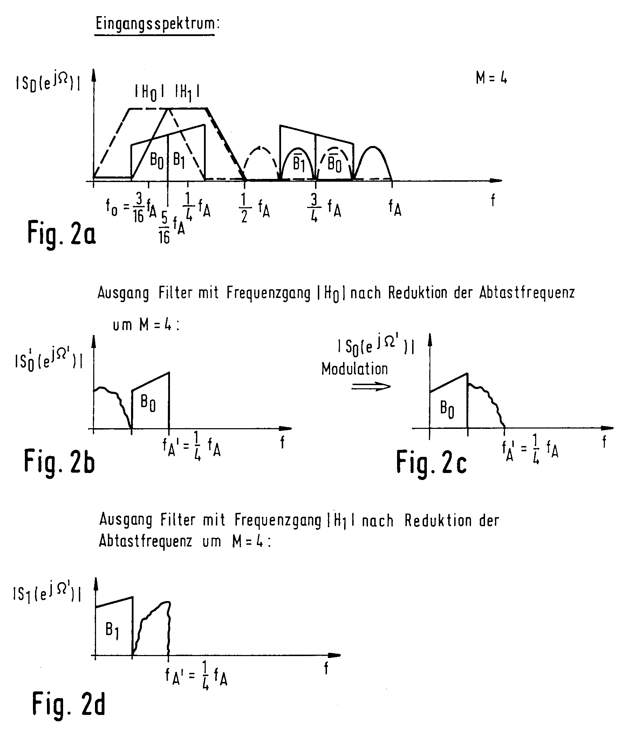

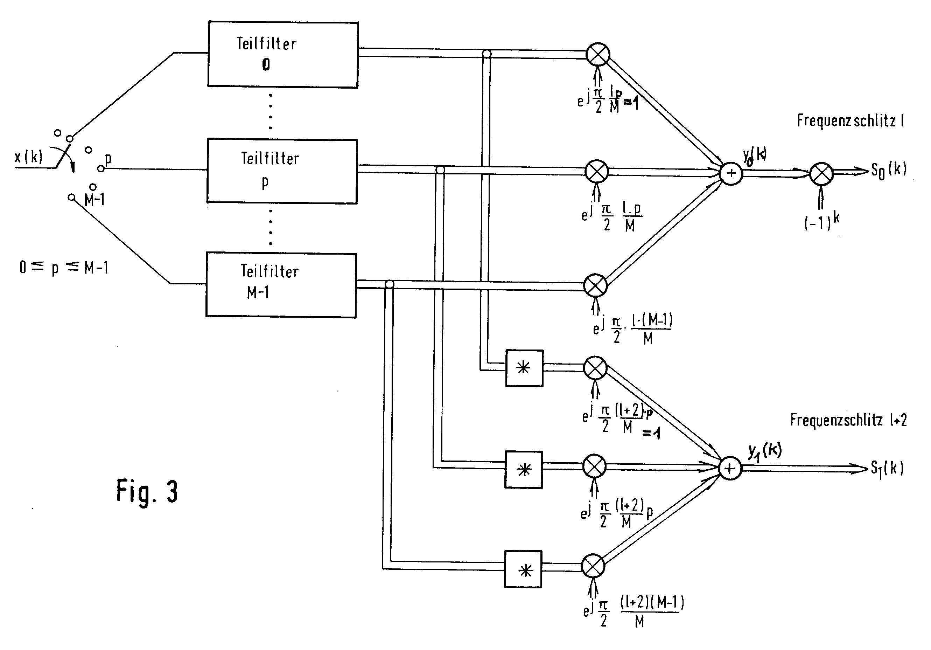

Die Erfindung bezieht sich auf eine digitale Filterbank gemäß Oberbegriff des Anspruches 1 bzw. 4. Solche digitalen Filterbänke werden eingesetzt zum Demultiplexen und Multiplexen digitalisierter Frequenzmultiplexsignale. Sie sind beschrieben beispielsweise in dem Aufsatz "A Modular Multistage Approach to Digital FDM Demultiplexing for Mobile SCPC Satellite Communications" von Heinz Göckler in International Journal of Satellite Communications, Vol. 6, Seite 283 bis 288, 1988, [1] oder in der europäischen Patentschrift 274 474 B1, [2]. In dem genannten Aufsatz von Göckler wird in der ersten Stufe eines hierarchischen Mehrstufen (HMM-) Demultiplexers die Abtastfrequenz eines reellen Eingangssignales um den Faktor 2 vermindert und das reelle Eingangssignal in ein komplexes Ausgangssignal transformiert (Digital Antialiasing Filter, DAF, siehe Figur 2 von [1]). In den nachfolgenden Stufen wird die Abtastfrequenz sukzessiv um den Faktor 2 vermindert und das Eingangsspektrum des Nutzbandes in zwei gleichgroße Nutzbänder aufgespalten, siehe Figur 2 und Figur 3 von [1].

Bei den bekannten digitalen HMM-Filterbänken mit vielen Einzelkanälen und/oder breitbandigen Einzelkanälen mit stufenweiser Herabsetzung der Abtastrate jeweils um den Faktor 2 kann die Abtastfrequenz für die Signalverarbeitung mindestens in den Eingangsstufen so hoch werden, daß sie mit der zur Verfügung stehenden Technologie nicht realisierbar ist.

Der vorliegenden Erfindung lag die Aufgabe zugrunde, eine digitale Filterbank zur spektralen Trennung bzw. Zusammenführung von Frequenzmultiplexsignalen der eingangs genannten Art anzugeben, die eine Signalverarbeitung mit einer um einen Faktor >2 niedrigeren Abtastfrequenz am Eingang eines FDM-DeMux bzw. am Ausgang eines FDM-Muxes ermöglicht, so daß eine technologische Realisierung aufwandsgünstig erfolgen kann. Dabei soll die Handhabbarkeit der bekannten Filterbänke erhalten bleiben, d.h. die Eigenschaften sollen nicht beeinträchtigt werden, insbesondere sollen Modularität, Flexibilität, Rekonfigurierbarkeit erhalten bleiben und der Schaltungsaufwand nicht vergrößert werden.

Diese Aufgabe wurde gelöst durch die Merkmale des Anspruches 1 bzw. 11. Vorteilhafte Ausgestaltungen ergeben sich durch die Unteransprüche.

Die Vorteile der vorliegenden digitalen Filterbank liegen darin, daß sie in den Eingangsstufen eines FDM-Demultiplexers bzw. in den Ausgangsstufen eines FDM-Multiplexers eine Herabsetzung der Abtastfrequenz um einen entsprechenden Faktor bewirkt, so daß diese Eingangs- bzw. Ausgangsstufen mit einer Signalverarbeitungsfrequenz arbeiten können, die mit vorhandenen technologischen Bauelementen realisierbar sind. Die Eigenschaften der bekannten digitalen Filterbänke werden dabei nicht beeinträchtigt, das heißt die Modularität, Flexibilität, Rekonfigurierbarkeit bleiben erhalten, und auch der Schaltungsaufwand wird kaum größer.

Mit der erfindungsgemäßen digitalen Filterbank wird die Abtastfrequenz in einem einzigen Schritt um den Faktor M>2 vermindert, so daß alle Operationen in den erfindungsgemäßen Eingangsfilterstufen einer FDM-Baumstruktur bzw. in den Ausgangsfilterstufen einer FDM-Multiplexerstruktur mit der Abtastfrequenz $f_A/M$ ausführbar sind. Gleichzeitig werden die gewünschten Frequenzbänder direkt herausgefiltert bzw. direkt zusammengesetzt. Wenn die Abtastrate um den Faktor M erniedrigt wird, so erhält man M/2 Frequenzbänder, welche durch M/2 komplexe Signale beschrieben sind.

Es folgt nun die Beschreibung der Erfindung anhand der Figuren.

Die Figur 1a zeigt die Eingangsfilterschaltung eines HMM-DeMuxers gemäß dem Stande der Technik. Die Figur 1b zeigt ein Blockschaltbild gemäß der Erfindung als Ersatz für die Anordnung nach Figur 1a, und die Figur 1c zeigt die dazu inverse Anordnung für einen erfindungsgemäßen Multiplexer.

In der Figur 3 und in der Figur 4 sind detailliertere Anordnungen für das erfindungsgemäße Weichenfilter gezeichnet. Schließlich zeigt Figur 5 eine vereinfachte Struktur für die Zusammenfassung von Teilfilterausgangssignalen.

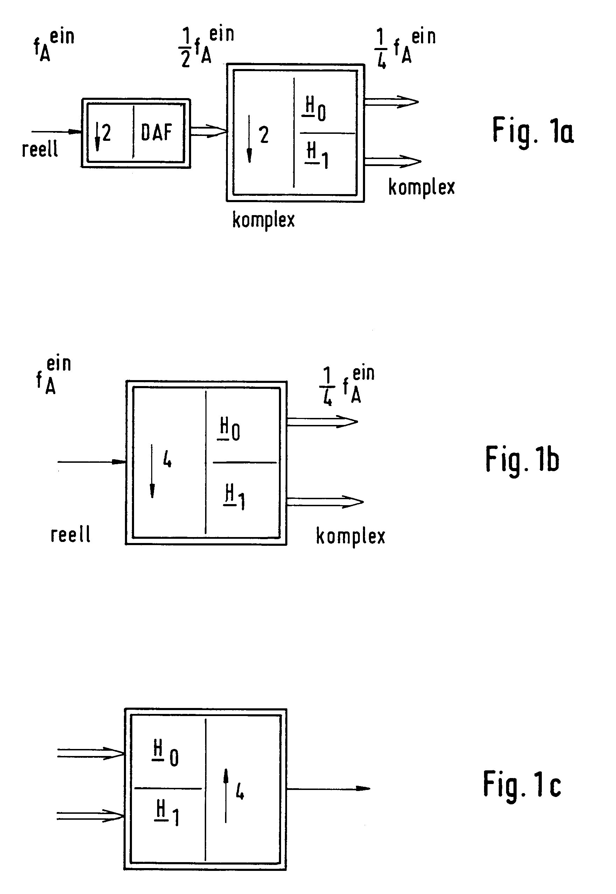

Beim Ausführungsbeispiel der erfindungsgemäßen Lösung gemäß Figur 1b werden in einem einzigen Schritt die Abtastfrequenz um den Wert M = 4 herabgesetzt und die beiden gewünschten Bänder B0 und B1 direkt herausgefiltert. Die dazu nötigen Operationen können dadurch bei der niedrigeren Abtastfrequenz von 1/4 $f_A$ ein durchgeführt werden. Die Figuren 2a bis 2d zeigen die dazu gehörenden Frequenzdiagramme. In Figur 2a ist das Eingangsspektrum aufgezeichnet, welches der Figur 3 des zitierten Aufsatzes [1] entspricht. Die Frequenzgänge H0 und H1 ergeben sich aus dem Frequenzgang eines Prototypfilters durch Gewichten der Filterkoeffizienten gemäß der folgenden Gleichung

$$c(n) = h(n) \cdot e^{j2\pi f_V n / f_A} \text{ für } n = 0, 1, \dots \text{ bis N-1}, \qquad (1).$$

Es wird eine Frequenzverschiebung des Spektrums erreicht, wobei $f_V = f_A \cdot 3/16$ bzw. $f_V = f_A \cdot 5/16$ gewählt wurde. Im Eingangsspektrum befinden sich die beiden Nutzbänder B0 und B1, wobei die Kanalmittenfrequenzen bei

$$fl' = l' \cdot B + B \cdot n'/m' = (l' \cdot m' + n') B/m' \qquad (2)$$

liegen mit $n'/m' = 1/2$ und der laufenden Nummer l' des Kanals mit der Nutzbandbreite B. Die beiden Nutzbänder werden getrennt; das eine komplexe Ausgangssignal ergibt das Spektrum B0 gemäß Figur 2b, das noch um die Verschiebefrequenz $fv = f_A'/2$ zu tieferen Frequenzen hin verschoben werden muß, siehe Figur 2c, und das andere komplexe Ausgangssignal ergibt das Nutzspektrum B1 gemäß Figur 2d.

Im folgenden werden die Filterfunktionen c(n) gemäß Gleichung (1) aus einem Prototypfilter mit den Koeffizienten h(n) allgemein abgeleitet, wobei die Verschiebungsfrequenz fv die Werte der einzelnen Kanalmittenfrequenzen fl' anzunehmen haben.

Für den Fall $f_A = 2MB$ (siehe Fig. 2a) gilt

$$fv/f_A = fl'/f_A = (m' \cdot l' + n') B/(2MB \cdot m') = l/(4M) \text{ d.h. } l = 2(m' \cdot l' + n')/m' \text{ mit } l, n', m' \in N \qquad (2a).$$

Für den Fall der Fig. 2a ist $n' = 1$, $m' = 2$, so daß l sinnvollerweise nur ungerade Werte annimmt, da die Bandmittenfrequenz des Frequenzganges nicht auf eine Kante des Nutzspektrums fallen soll. Die Gleichungen (2) und (2a) für die Verschiebungsfrequenz fv gelten nicht nur für den Fall, daß die Kanalmittenfrequenzen $fl' = B(l' + 1/2)$ ist wie beispielsweise in Figur 2a, sondern auch für den Fall, daß die Kanalmittenfrequenzen ganze Vielfache der Bandbreite B sind, also $fl' = l' \cdot B$. Hierbei sind gemäß der Funktion $l = 2l' + 2$ für l jeweils nur gerade Werte einzusetzen.

Ist x(k) das Eingangssignal des FIR-Filters, so ergibt sich unter Verwendung der Gleichungen (1), (2) und (2a) das gefilterte Ausgangssignal $\underline{y}(k)$ zu:

$$\underline{y}(k) = \sum_{n=0}^{N-1} h(n) \cdot e^{j2\pi ln/(4M)} \cdot x(k-n) \qquad (3).$$

Aufgrund der Dezimation um den Faktor M werden M Teilfilter abgespalten. Dann ergibt sich aus Gleichung (3)

$$\underline{y}(k) = \sum_{p=o}^{M-1} \sum_{n=0}^{\lfloor \frac{N-1}{M} \rfloor} h(Mn + p) \cdot e^{j\pi l(Mn+p)/(2M)} \cdot (k-(Mn+p)) \qquad (4).$$

Die innere Summation berechnet das Ausgangssignal des p-ten Teilfilters. Die Entier-Funktion $\lfloor (N-1)/M \rfloor$ bezeichnet die größte ganze Zahl $<= (N-1)/M$.

Werden die Anteile, die unabhängig vom Summationsindex sind, vor die Summation genommen, so schreibt sich die Gleichung (4) wie folgt

$$\underline{y}(k) = \sum_{p=0}^{N-1} e^{j\pi/2 \cdot lp/M} \cdot \sum_{h=0}^{\lfloor \frac{N-1}{M} \rfloor} j^{ln} \cdot h(Mn+p) \cdot x(k-(Mn+p)) \qquad (5).$$

Aus Gleichung (5) folgt, daß das Ergebnis der reellen Multiplikationen abwechselnd einem Realteil bzw. Imaginärteil zugeordnet werden (Faktor $j^{ln}$ mit $j = \sqrt{-1}$).

Betrachtet man das Signal des benachbarten Nutzbandes, das ist also der Frequenzschlitz $l + 2$, so gilt $(j^{l+2})n = (-1)^n \cdot j^{ln}$. Das bedeutet, daß für den Fall, daß die Bandmittenfrequenzen bzw. die Kanalmittenfrequenzen $fl' = l' \cdot B + 1/2 \cdot B$ sind, also für den Fall, daß l ungerade Werte anzunehmen hat, die Teilfilter-Ausgangssignale für den benachbarten Schlitz $l+2$ sich als konjugiert komplexe Ausgangssignale des Frequenzschlitzes l ergeben. Dies folgt aus Gleichung (5), da für ungerades n die Imaginärteile der Ausgangssignale mit negativem Vorzeichen zu versehen sind. Dies wird verdeutlicht durch die Figur 3, wo der Block mit dem Sternchen bedeutet, daß der Imaginärteil negiert wird.

Für den anderen Fall, daß die Kanalmittenfrequenzen ganze Vielfache der Bandbreite B sind, d.h. l nur gerade Werte annimmt, ergibt die Gleichung (5) als Teilfilterausgangssignal ein reelles Signal, weil die Imaginärteile wegfallen. Das ergibt bei der nachfolgenden komplexen Multiplikation eine Einsparung von zwei Multiplikatoren und zwei Summatoren pro Teilfilter. Die Figur 3 zeigt, wie das Eingangssignal x(k) mittels eines Verteilerschalters auf die M Teilfilter verteilt wird. Das komplexe Ausgangssignal der einzelnen Teilfilter muß gemäß Gleichung (5) noch mit dem komplexen Vektor $e^{j\pi/2l\cdot p/M}$ multipliziert werden, um dann über alle Teilfilter summiert zu werden. Wie schon in Figur 2b dargestellt, muß anschließend das Spektrum B0 für den Frequenzschlitz l' = 1(l = 3) um die halbe Abtastrate verschoben werden, was einer komplexen Multiplikation des Summensignals $y_0(k)$ mit $(-1)^k$ entspricht und zum Nutzsignal S0(k) führt. Für den benachbarten Frequenzschlitz l = l + 2 ergibt sich das Gleiche mit dem Unterschied, daß die Teilfilterausgangssignale komplex konjugiert werden, anschließend mit $e^{j(l+2)p/(2M)}$ komplex multipliziert werden und nach der Zusammenfassung direkt das Nutzausgangssignal S1(k) = $\underline{y}1(k)$ liefern.

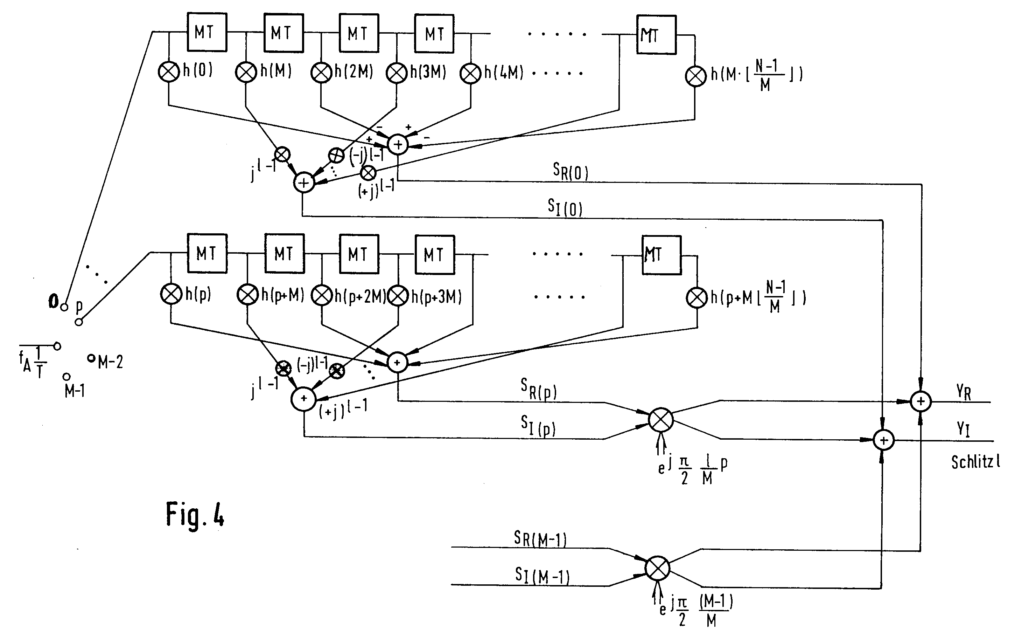

In Figur 4 ist die erfindungsgemäße Lösung für den allgemeinen Schlitz l dargestellt, wobei die einzelnen Teilfilterblöcke im Detail wiedergegeben sind durch eine Verzögerungsglieder-Kette MT, deren Ein bzw. Ausgangssignale jeweils mit den Filterkoeffizienten h(n) multipliziert und anschließend zusammengefasst werden zu den komplexen Ausgangssignalen der einzelnen Teilfilter.

Durch Zusammenfassung einzelner Teilfilterausgangssignale läßt sich die Struktur weiter vereinfachen. Für den Drehfaktor nach dem p-ten Teilfilter gilt mit der Einschränkung $0 < = p < = M/2-1$ für $e^{j\pi lp/(M2)} = E_R + E_I$ mit

$$E_R = \cos(\pi/2lp/M) \text{ und } E_I = \sin(\pi/2lp/M) \qquad (6).$$

Für einen Index M-p gilt dann

$$e^{j\pi/2l(M-P)/M} = e^{j\pi/2l} \cdot e^{-j\pi/2lp/M} = j^l [E_R - jE_I] \qquad (7).$$

Das Ausgangssignal des Teilfilters berechnet sich gemäß Gleichung (5) zu

$$\underline{y}p(k) = Y_{Rp} + j\, Y_{Ip} = \sum_{n=0}^{\left\lfloor \frac{N-1}{M} \right\rfloor} j^{ln}\, h(Mn+p) \cdot x(k-(Mn+p))$$

Aus Gleichung (5) ergibt sich für die Summation zweier Teilsummen gemäß Figur 3

$$[y_{Rp}(k) + jy_{Ip}(k)] \cdot e^{j\pi/2\cdot lp/M}$$
$$+ [y_{RpM-p}(k) + jy_{IM-p}(k)] \cdot e^{j\pi/2l(M-p)/M}$$
$$= [y_{RP} + j^{l+1} \cdot y_{IM-p}] \cdot E_R - [y_{Ip} + j^{l+1} \cdot y_{RM-p}] E_I$$
$$+ j[(y_{Ip} + j^{l-1} \cdot y_{RM-p}) E_R + (y_{Rp} + j^{l-1} \cdot y_{IM-p}) E_I] \qquad (8).$$

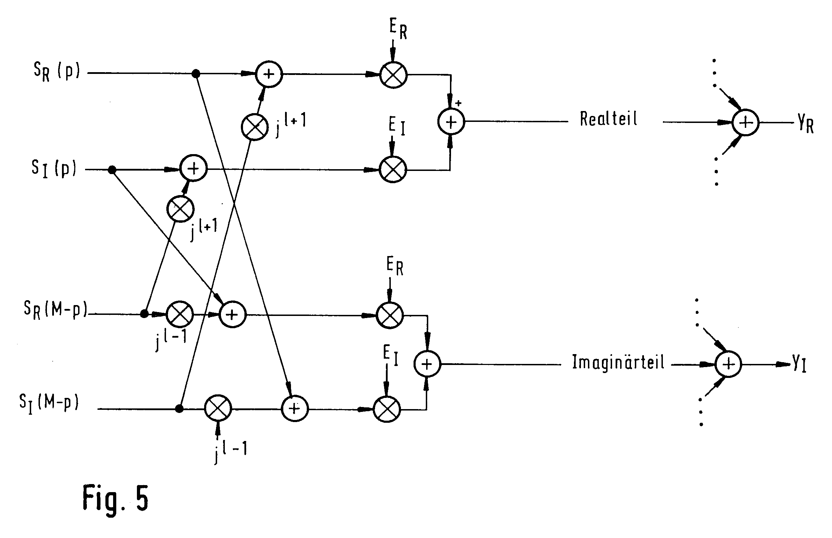

Die Struktur der Gleichung (8) ist in Figur 5 für den Fall daß l ungerade ist, dargestellt. Für gerade Werte von l wird in der Struktur der Figur 5 lediglich Imaginärteil und Realteil vertauscht.

Durch Transposition der erfindungsgemäßen Filterstruktur erhält man einen Frequenzmultiplexer, mit dem man in entsprechend umgekehrter Weise Frequenzbänder zu einem Frequenzmultiplexsignal zusammensetzen kann.

**Patentansprüche**

1. Digitale Filterbank zur frequenzmäßigen Trennung eines mit der Abtastfrequenz $f_A = 1/T$ abgetasteten aus höchstens L Einzelsignalen der Bandbreite B zusammengesetzten Frequenzmultiplexsignals, für Kanalmittenfrequenz fl' = l' · B + Bn'/m', wobei l' die laufende Nummer des Kanals mit 1, 2 ...L und n', m'$_\epsilon$ N ist wobei ein reelles Eingangssignal x(kT), mit k als laufendem Zeitindex ... -1,0, +1, ..., in ein komplexes Ausgangssignal umgewandelt und die Abtastrate verkleinert wird, dadurch gekennzeichnet, daß in einer einzigen Filterstufe das reelle Eingangssignal mittels eines rotierenden Schalters (DeMux) im Takte der Eingangsabtastrate fA = 1/T auf M Teilfilter verteilt wird, wodurch die Verarbeitungsrate in den Teilfiltern um den Faktor M mit M$_\epsilon$ N und M>2 herabgesetzt wird (Dezimation), daß in den einzelnen Teilfiltern für das p-te Teilfilter mit $0 > = p > = M-1$ die Abtastproben des Eingangssignals mit den Filterkoeffizienten multipliziert, mittels komplexer Multiplikation frequenzverschoben und nach der folgenden Gleichung zu den komplexen Teilfilter-Ausgangssignalen zusammengefasst wer-

den:

$$\underline{y}p(k) = \sum_{n=0}^{\lfloor\frac{N-1}{M}\rfloor} h(M{\cdot}n+p) \cdot x(k-(M{\cdot}n+p)) \cdot e^{j2\pi nfl'/f_A{\cdot}M}$$

(5')

mit dem Filtergrad N-1, der laufenden Nummer 0< = n< = N der einzelnen Koeffizienten im gesamten Filter, wobei sich im p-ten Teilfilter folgende Koeffizientenreihenfolge ergibt: n = p, (M), N-1, mit [(N-1)-/M] als der nächstniedrigen ganzen Zahl aus (N-1)/M, für den l'-ten Frequenzschlitz mit 1< = l'< = M/2 = L, und
daß die Teilfilterausgangssignale zusammengefaßt werden zu den komplexen Filterausgangssignalen

$$\underline{y}(k) = \sum_{n=0}^{N-1} h(n) \cdot e^{j2\pi nfl'/f_A} \cdot x(k-n) = \sum_{p=0}^{M-1} \underline{y}p(k)$$

(3,5'').

2. Digitale Filterbank nach Anspruch 1, dadurch gekennzeichnet, daß der Dezimationsfaktor die Werte $M = 2^i$ mit i≧2 erhält.

3. Digitale Filterbank nach einem der vorhergehenden Ansprüche, dadurch gekennzeichnet, daß die Eingangsabtastrate zu $f_A$ = 4B • (L/2 + n'/m') gewählt wird.

4. Digitale Filterbank nach Anspruch 2 oder 3, dadurch gekennzeichnet, daß n'/m' = L/2 gewählt wird, daß fl' die Werte B(L/2 + 1/2) bis B(3L/2 - 1/2) annimmt und daß die Abtastfrequenz zu $f_A$ = 4L • B gewählt wird.

5. Digitale Filterbank nach Anspruch 2 oder 3, dadurch gekennzeichnet, daß n'/m' = $\epsilon$ N gewählt wird, daß gilt n'/m' = (L ± 1)/2 und daß die Abtastfrequenz zu $f_A$ = 2(2L±1)B gewählt wird.

6. Digitale Filterbank nach einem der vorhergehenden Ansprüche, dadurch gekennzeichnet, daß sich die Teilfilter-Ausgangssignale für den l+2-ten Frequenzschlitz durch die konjugiert komplexen Werte der Teilfilter-Ausgangssignale für den nächst niedrigeren l-ten Frequenzschlitz ergeben (Fig. 3).

7. Digitale Filterbank nach Anspruch 5, dadurch gekennzeichnet, daß die Teilfilter-Ausgangssignale reell sind.

8. Digitale Filterbank nach einem der vorhergehenden Ansprüche, dadurch gekennzeichnet, daß zur Bildung des Ausgangssignales für den l-ten Frequenz-Schlitz jeweils das p-te und das M-p-te Teilfilterausgangssignal durch Kombination von Realteil des einen mit Imaginärteil des anderen und umgekehrt zu zwei komplexen Werten zusammengefaßt und anschließend mit der Größe $E_R$ = cos ($\pi$/2 l p/M) bzw. $E_I$ = sin ($\pi$/2 l p/M) multipliziert und zum Real- bzw. Imaginärteil des Filterausgangssignals zusammengefaßt werden (Fig. 5).

9. Digitale Filterbank nach einem der vorhergehenden Ansprüche, dadurch gekennzeichnet, daß sie als Kopfstufe oder erste Stufe (Baumspitze) eingesetzt ist in einer hierarchischen Mehrstufenanordnung (HMM), welche mehrere digitale Filterbänke umfaßt, die in einer Baumstruktur stufenweise sich verzweigend hintereinander angeordnet sind, wobei ab der Stufe 2 Realteil und Imaginärteil des komplexen Eingangssignals jeweils in gleiche Anordnungen gespeist werden und diese Anordnungen jeweils aus einem Eingangsdemultiplexer (rotierender Schalter) mit $M_\mu$ Stellungen besteht und wobei in der $\mu$-ten Stufe mit $\mu$ = 2, 3,... eine Separierung in $L_\mu$ Einzelsignale erfolgt und die Abtastrate jeweils um den Faktor $M_\mu$ vermindert wird.

5

**10.** Digitale Filterbank nach Anspruch 9, dadurch gekennzeichnet, daß nach der ersten Stufe in jeder folgenden Stufe $\mu \geq 2$ die Abtastrate um den Faktor $M_\mu = 2$ dezimiert und dementsprechend in jeder Stufe $\mu$ aus $2^{(\mu - 2)}$ M/2 komplexen eingangsseitigen Frequenzmultiplexsignalen eine Separierung in $M \cdot 2^{(\mu - 2)}$ komplexe Ausgangssignale erfolgt mit

$$\mu <= \quad \mathrm{ld} \frac{4L'}{M},$$

wobei L' die Gesamtzahl der Kanäle in der Mehrstufenanordnung ist.

**11.** Digitale Filterbank zur frequenzmäßigen Zusammenführung (Frequenzmultiplexbildung) von höchstens L mit der Abtastfrequenz $f_A$/M mit M<=L, abgetasteten Einzelsignalen der Bandbreite B, dadurch gekennzeichnet, daß eine digitale Filterbank nach einem der vorhergehenden Ansprüche verwendet wird, wobei alle Signalflußrichtungen umgekehrt sind, Ein- und Ausgänge der Filterbank vertauscht sind, Summierer durch Verzweigungspunkte und Verzweigungspunkte durch Summierer ersetzt sind, wobei sofern verwendet, eine diskrete Transformation (DFT) durch die inverse diskrete Transformation ersetzt ist, wobei die Verminderung der Abtastfrequenz $f_A$ um den Faktor M (Dezimation) durch die Erhöhung der Abtastfrequenz $f_A$/M um den Faktor M (Interpolation) ersetzt ist und wobei alle Schaltfunktionen zum Demultiplexen durch solche zum Multiplexen ersetzt sind (Transposition digitaler Netzwerke).

Fig. 1a

Fig. 1b

Fig. 1c

Eingangsspektrum:

**Fig. 2a**

Ausgang Filter mit Frequenzgang $|H_0|$ nach Reduktion der Abtastfrequenz um $M = 4$:

**Fig. 2b**

**Fig. 2c**

Ausgang Filter mit Frequenzgang $|H_1|$ nach Reduktion der Abtastfrequenz um $M = 4$:

**Fig. 2d**

Fig. 3

Fig. 4

Fig. 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| D,A | DE-A-36 10 195 (ANT) 1. Oktober 1987<br>* das ganze Dokument *<br>----- | 1 | H03H17/02 |

|  |  |  | **RECHERCHIERTE SACHGEBIETE (Int.Cl.6)** |
|---|---|---|---|
|  |  |  | H03H |

Der vorliegende Recherchenbericht wurde für alle Patentansprüche erstellt

| Recherchenort | Abschlußdatum der Recherche | Prüfer |
|---|---|---|
| DEN HAAG | 7. Dezember 1994 | COPPIETERS, C |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
........................................................................................
& : Mitglied der gleichen Patentfamilie, übereinstimmendes
    Dokument